Europäisches Patentamt

European Patent Office

Office européen des brevets

(11) Veröffentlichungsnummer: **0 416 141 A1**

## (12) EUROPÄISCHE PATENTANMELDUNG

(21) Anmeldenummer: 89116311.5

(22) Anmeldetag: 04.09.89

(51) Int. Cl.5: **H01L 21/338**

(43) Veröffentlichungstag der Anmeldung:
**13.03.91 Patentblatt 91/11**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Willer, Josef, Dr.**
**Friedrich-Fröbel-Strasse 62**
**W-8012 Riemerling(DE)**
Erfinder: **Lefranc, Guy**
**Nymphenburger Strasse 153**
**W-8000 München 19(DE)**

(54) Verfahren zur Herstellung eines FET mit asymmetrisch angeordnetem Gate-Bereich.

(57) Verfahren zur Herstellung eines Feldeffekttransistors mit asymmetrisch zum Gate-Bereich angeordneten Source- und Drain-Bereichen, bei dem im Bereich des auszubildenden Gates eine streifenförmige Hilfsschicht (B) aufgebracht wird, seitlich längs dieser Hilfsschicht (B) Spacer (D, E) ausgebildet werden, mittels einer Lackmaske (F) der erste Spacer (D) abgedeckt und der zweite Spacer (E) weggeätzt wird, danach die Source-Metallisierung (G) und die Drain-Metallisierung (H) aufgebracht werden und schließlich dazwischen eine planarisierende Passivierungsschicht (N) sowie die Verbindungsmetallisierungen (K, L, M) aufgebracht werden.

FIG.1

FIG.2

FIG.3

FIG.4

EP 0 416 141 A1

## VERFAHREN ZUR HERSTELLUNG EINES FET MIT ASYMMETRISCHEN GATE-BEREICH

Die Erfindung betrifft Feldeffekttransistoren auf Halbleitersubstraten, insbesondere GaAs-MESFET und -HEMT. Bei der Optimierung von symmetrisch aufgebauten Feldeffekttransistoren bestehen zwei einander teilweise ausschließende Forderungen, nämlich nach möglichst niedrigem Source-Widerstand einerseits und einer moderaten Drain-Implantation andererseits (sog. $\underline{L}$ ightly $\underline{D}$ oped $\underline{D}$ rain), zwischen denen nur ein $\overline{Kompromiß}$ zu finden ist. Die erstgenannte Forderung ergibt eine möglichst hohe Steilheit und geringes Rauschen, die zweite eine möglichst hohe Durchbruchsspannung und große Leistung. Dieser Zielkonflikt kann nur durch eine asymmetrische Gestaltung der Source- bzw. Drain-Bereiche in Bezug auf das Gate vermieden werden. Des weiteren sind möglichst kurze Gatelängen für gute Hochfrequenztauglichkeit erforderlich; eine kurze Gatelänge führt aber in der Regel zu starken Kurzkanaleffekten, die durch einen LDD-Bereich ebenfalls weitgehend unterdrückt werden können.

In der Veröffentlichung T. Enoki, K. Yamasaki, K. Osafune K. Ohwada: "0,3 $\mu$m Advanced SAINT FETs Having Asymmetric $n^+$- Layers for Ultra-High-Frequency GaAs MMICs", IEEE Trans Electron Devices $\underline{ED-35}$, 18-24 (1988), ist ein Feldeffekttransistor $\overline{mit}$ asymmetrischen Source- bzw. Drain-Bereichen beschrieben. Dieser FET wird hergestellt, indem im Bereich des Gates eine Lackmaske mit T-förmigem Querschnitt aufgebracht wird und mittels einer schräg auftreffenden Implantation die Source- und Drain-Bereiche hergestellt werden. Die von der Lackmaske nicht bedeckten Teile der Oberfläche werden anschließend mit einer Schicht SiO$_2$ bedeckt, die Lackmaske entfernt und mit der SiO$_2$-Schicht als Maske selbstjustierend eine Metallisierung für das Gate aufgebracht.

In der Veröffentlichung T. Kimura, K. Inokuchi, M. Akiyama, M. Sakuta: "Asymmetrie Implantation Self-alignment Technique for GaAs MESFETs", Jap. J. Appl. Phys. $\underline{27}$, L1340-L1343, (1988), ist ein Feldeffekttransistor mit asymmetrisch dotierten Source-und Drain-Bereichen beschrieben. Dieser FET wird hergestellt, indem zunächst ein hochtemperaturfestes Metall als Gate-Metallisierung aufgebracht wird. Anschließend wird ganzflächig eine Germanium-Schicht aufgebracht und darauf ein Resist. Durch eine Öffnung in diesem Resist im Bereich des auszubildenden Source-Bereiches wird ein darunter befindlicher Anteil der Germanium-Schicht bis zu dem Gate-Metall hin weggeätzt. Nach dem Abtragen des Resist verbleibt eine Germanium-Schicht mit einer Öffnung im Bereich des Source-Bereiches. Durch diese Öffnung wird eine Ionenimplantation in den Source-Bereich vorgenommen. Nach dem Entfernen der Germanium-Schicht kann eine weitere Ionenimplantation symmetrisch für Source-Bereich und Drain-Bereich vorgenommen werden. Anschließend erfolgt das Ausheilen der Dotierung. Durch das zweimalige Dotieren des Scurce-Bereiches ergibt sich eine Asymmetrie zwischen dem Source- und dem Drain-Bereich.

In der Veröffentlichung von A. E. Geissberger, I. J. Bahl, E. L. Griffin, R. A. Sadler: "A New Refractory Self-Aligned Gate Technology for GaAs Microwave Power FETs and MMICs", IEEE Trans. Electron Devices $\underline{ED-35}$, 615-622 (1988), wird ein Feldeffekttransistor $\overline{mit}$ asymmetrisch ausgebildeten Source- und Drain-Bereichen beschrieben, dessen Herstellung ebenfalls unter Verwendung eines hochtemperaturfesten Metalles für die Gate-Metallisierung erfolgt. Dabei wird nach dem Aufbringen der Gate-Metallisierung durch eine einseitig aufgebrachte streifenförmige Schicht aus einem Resist für eine asymmetrische Implantation von Dotierung gesorgt. Das Gatemetall ist dann bezüglich dieser implantierten Source- und Drain-Bereiche asymmetrisch angeordnet.

Aufgabe der vorliegenden Erfindung ist es, ein Herstellungsverfahren für einen Feldeffekttransistor mit asymmetrisch angeordnetem Gate anzugeben, der selbstjustierend und einfach auszuführen ist und mit dem sehr kurze Gatelängen realisierbar sind.

Diese Aufgabe wird mit dem Verfahren mit den Merkmalen des Anspruches 1 gelöst. Weitere Ausgestaltungen ergeben sich aus den Unteransprüchen.

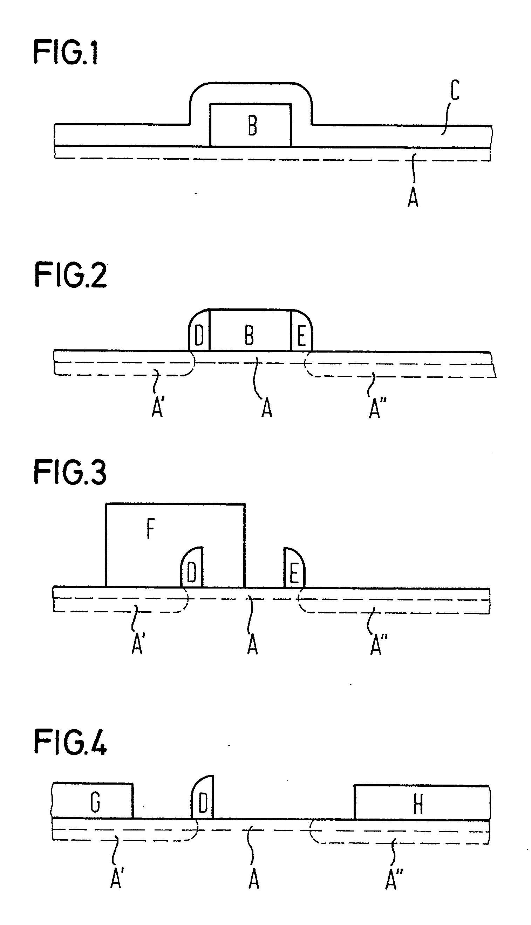

Es folgt eine Beschreibung des erfindungsgemäßen Herstellungsverfahrens anhand der Figuren 1 bis 11, die einen erfindungsgemäß hergestellten Feldeffekttransistor im Querschnitt jeweils im Anschluß an verschiedene Verfahrensschritte zeigen.

Das erfindungsgemäße Verfahren besteht darin, daß das spätere Gate zunächst als sog. side wall spacer an einer Hilfsschicht gebildet wird. Die Source- und Drain-Bereiche werden hierzu symmetrisch ausgebildet. Einer der beiden Spacer wird anschließend weggeätzt, während der andere auf der Oberfläche als Gate-Metallisierung verbleibt und folglich asymmetrisch in Bezug auf Source und Drain ist.

Fig. 1 zeigt eine leitfähige Schicht A an der Oberfläche eines Substrates oder als oberste Schicht eines Schichtaufbaues mit einer darauf aufgebrachten strukturierten Hilfsschicht B, die streifenförmig längs des für das Gate vorgesehenen Bereiches verläuft. Das Substrat kann z. B. durch selektive Implantation dotiert sein und die Hilfsschicht B z. B. Aluminium sein, das mittels Abhebetechnik streifenförmig strukturiert wird. Durch ein weitgehend konformes Abscheideverfahren wird eine Metallschicht C aus hochtemperaturfestem Gate-Metall (z. B. $WSi_{0,4}$) ganzflächig abgeschieden.

Diese Metallschicht C wird anisotrop bis auf einen ersten und einen zweiten Spacer D, E rückgeätzt. Anschließend erfolgt $n^+$-Implantation des Source-Bereiches $A'$ und des Drain-Bereiches $A''$, die bezüglich dieser aus der Hilfsschicht B mit den beiden Spacern D, E bestehenden Struktur selbstjustiert erfolgt. Die Implantation kann bezüglich möglicher weiterer Strukturen auf der Oberfläche der leitfähigen Schicht A durch eine geeignet justierte Lackmaske begrenzt werden. Den damit erreichten Aufbau mit den implantierten Bereichen zeigt Fig. 2 im Querschnitt.

Bei einer vorteilhaften Ausgestaltung des Verfahrens wird anschließend die Hilfsschicht B selektiv weggätzt, was z. B. bei Aluminium durch HCl geschehen kann. Gegebenenfalls kann auch in diesem Stadium des Verfahrens die eingebrachte Dotierung in einem Temperschritt (typisch 800 °C/20 min) aktiviert werden. Mit Hilfe einer justierten Lackmaske F wird der erste Spacer D abgedeckt, so daß der zweite Spacer E selektiv geätzt werden kann. Dafür eignet sich z. B. reaktives Ionenätzen (RIE) z. B. mit $SF_6$-Gasgemischen. Der verbleibende erste Spacer D bildet die eigentliche Gate-Metallisierung. Vorteilhaft wird der Temperschritt zum Aktivieren der Dotierung nach diesem Abätzen des zweiten Spacers E ausgeführt. Auf diese Weise erhält man den Aufbau nach Fig. 3.

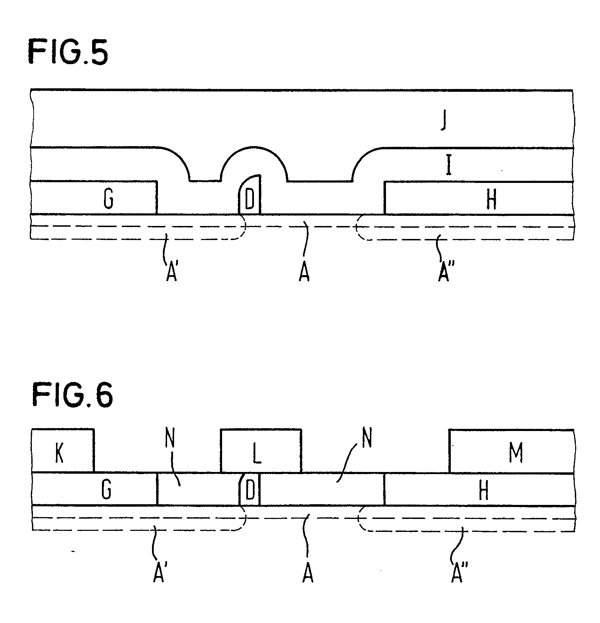

Fig. 4 zeigt den Aufbau aus Fig. 3 nach Entfernen der Lackmaske F und dem Abscheiden und Einlegieren der Source-Metallisierung G und der Drain-Metallisierung H aus einem für ohmsche Kontaktierung geeigneten Metall. Die Strukturierung geschieht z. B. mittels Abhebetechnik.

Danach wird ganzflächig kantenkonform eine Dielektrikumschicht J (z. B. $Si_3N_4$) und eine diese Dielektrikumschicht I einebnende Lackschicht 3 abgeschieden. Mittels eines geeigneten RIE-Prozesses kann die in Fig. 5 im Querschnitt gezeigte Struktur planarisiert werden, so daß die Oberflächen der Source-Metallisierung G, des ersten Spacers D und der Drain-Metallisierung H von der Dielektrikumschicht I freigelegt werden und von dieser Dielektrikumschicht I zwischen den Metallisierungen ein Anteil als Passivierungsschicht N stehenbleibt. Auf die dermaßen planarisierte Struktur werden die Verbindungsmetallisierungen jeweils oberhalb der Kontaktmetallisierungen aufgebracht. Die Source-Metallisierung G wird so mit einer ersten Verbindungsmetallisierung K, der erste Spacer D mit einer zweiten Verbindungsmetallisierung L, die durch die Passivierungsschicht N von den übrigen Metallisierungen isoliert ist, und die Drain-Metallisierung H mit einer dritten Verbindungsmetallisierung M in Abhebetechnik versehen. Die zweite Verbindungsmetallisierung L dient gleichzeitig als Verstärkung der Gate-Metallisierung, womit sich ein großer Gatequerschnitt ergibt.

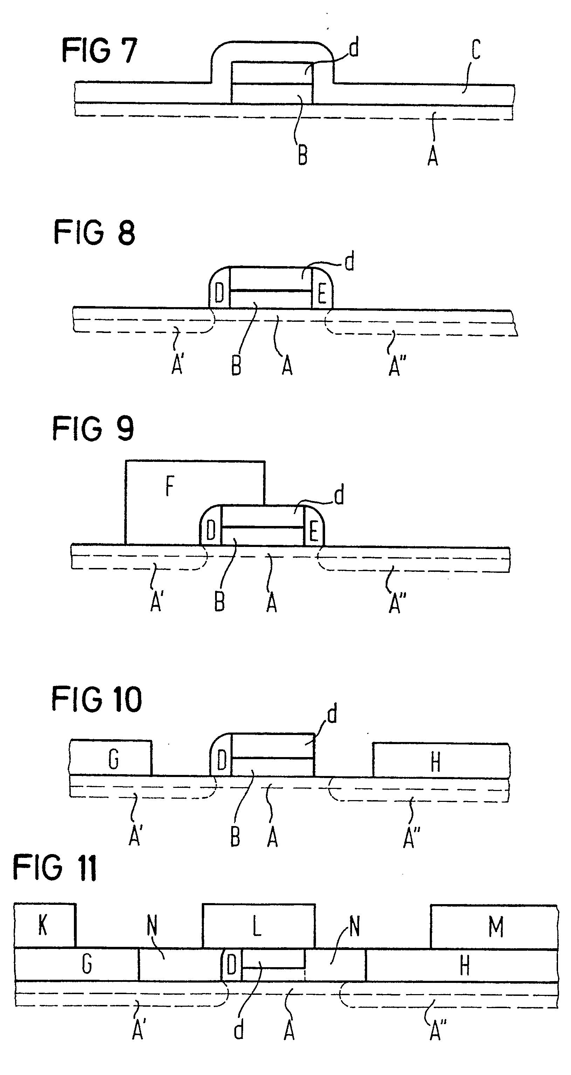

Als alternative Ausführungsmöglichkeit kann die Hilfsschicht B auch ein Dielektrikum sein, das ggf. bei den folgenden Verfahrensschritten auf der leitfähigen Schicht A verbleiben kann. Diese Hilfsschicht B kann entweder in einem späteren Verfahrensschritt entfernt werden oder als Teil der Passivierungsschicht N stehenbleiben. Bei Verwendung einer Hilfsschicht B aus einem Dielektrikum ist es auch möglich, den Gate-Querschnitt dadurch zu vergrößern, daß die Hilfsschicht B als Passivierung stehenbleibt und darauf eine mit dem ersten Spacer D in elektrischem Kontakt befindliche weitere Metallschicht abgeschieden wird. Das Herstellungsverfahren verläuft dann so, daß zunächst die streifenförmige Hilfsschicht B und darauf ein mit dieser Hilfsschicht B kantenkonform verlaufender Metallstreifen d abgeschieden werden. Darauf wird die Metallschicht C ganzflächig abgeschieden. Das Metall des Metallstreifens d kann z. B. Wolfram sein. Das Metall der Metallschicht C wird so gewählt, daß es sich selektiv bezüglich des Metalles des Metallstreifens d ätzen läßt. Den Fig. 1 entsprechenden Aufbau zeigt Fig. 7.

Wie in Fig. 8 dargestellt, wird die Metallschicht C bis auf Spacer D, E rückgeätzt. Der Metallstreifen d bleibt stehen. Entsprechend Fig. 9 wird der erste Spacer D mit einer Lackmaske F abgedeckt, so daß der freie zweite Spacer E weggeätzt werden kann. Wegen der Auswahl der verschiedenen Metalle der Metallschicht C und des Metallstreifens d kan der zweite Spacer E selektiv weggeätzt werden, so daß der Metallstreifen d stehenbleibt. Danach wird die Lackmaske F entfernt, so daß der in Fig. 10 dargestellte Aufbau übrig bleibt. Der erste Spacer D bildet den Metall-Halbleiter-Kontakt und grenzt an den Metallstreifen d. Die gesamte Gate-Metallisierung besteht daher aus dem ersten Spacer D und dem Metallstreifen d. Damit ergibt sich ein gegenüber dem oben beschriebenen Herstellungsverfahren ein Aufbau mit einem größeren Querschnitt der Gate-Metallisierung. Die kurze Gate-Länge, die erfindungsgemäß angestrebt wird, bleibt erhalten, weil der Metallstreifen d gegenüber dem Halbleitermaterial durch die passivierende Hilfsschicht B aus Dielektrikum (z. B. $Si_3N_4$) isoliert ist. Wie in Fig. 11 gezeigt, können die Zwischenräume zwischen der aufgebrachten Source-Metallisierung G, der Gate-Metallisierung D, d und der Drain-Metallisierung H mit einer Passivierungsschicht N aufgefüllt und die Oberfläche planarisiert werden. Verbindungsmetallisierungen K, L, M werden anschließend aufgebracht. Ebenso kann auch zuerst die Passivierungsschicht N aufgebracht und danach die Source-Metallisierung G und die Drain-Metallisierung H durch in diese Passivierungsschicht N geätzte Kontaktlöcher aufgebracht werden. Diese Variante des Herstellungsverfahrens hat den Vorteil, daß auf die Planarisierung der Oberfläche nach dem Aufbringen der Passivierung verzichtet werden kann.

Die Dielektrikumschicht I kann in einer weiteren Variante auch bereits nach dem Wegätzen des zweiten Spacers E aufgebracht werden und als Deckschicht bei der Aktivierung der $n^+$-Dotierung dienen. Die Source-Metallisierung G und die Drain-Metallisierung H müssen dann durch Kontaktlöcher, die in diese Dielektrikumschicht I hineingeätzt werden, abgeschieden werden. Des weiteren ist es möglich, nach dem Wegätzen des zweiten Spacers E eine LDD-Implantation durchzuführen, so daß der Drain-Bereich $A''$ im Vergleich zu dem zwischen Source und Drain verlaufenden Kanal etwas niederohmiger wird, ohne daß die Durchbruchsspannung nennenswert darunter leidet.

Die besonderen Vorteile des erfindungsgemäßen Herstellungsverfahrens sind insbesondere darin zu sehen, daß selbstjustierte, asymmetrisch zum Gate angeordnete Source- und Drain-Bereiche hergestellt werden können, womit sich ein geringer Source- Widerstand, hohe Steilheit, hohe Durchbruchsspannung und geringe Kurzkanaleffekte ergeben. Zweitens lassen sich mittels optischer Lithographie bei dem erfindungsgemäßen Herstellungsverfahren kurze Gatelängen im 100 nm-Bereich realisieren, während bei den herkömmlichen Herstellungsverfahren derartiger Bauelemente kurze Gatelängen in erster Linie durch mit Elektronenstrahl geschriebene Lackstrukturen hergestellt werden. Bei dem Schreiben mit Elektronenstrahl sind das Justieren und der eigentliche Schreibvorgang sehr zeitaufwendig. Drittens erhält man mit dem erfindungsgemäßen Verfahren ein niederohmiges Gate durch eine Gate-Verstärkung (zweite Verbindungsmetallisierung L) mit großem Querschnitt, dabei aber gleichzeitig ein alterungsbeständiges, hochtemperaturfestes Gate.

**Ansprüche**

1. Verfahren zur Herstellung eines Feldeffekttransistors mit asymmetrisch zum Gate-Bereich angeordneten Source- und Drain-Bereichen, bei dem in einem ersten Schritt auf eine leitfähige Schicht (A) an der Oberfläche eines Substrates eine symmetrisch zu den auszubildenden Source- und Drain-Bereichen und zwischen diesen angeordnete streifenförmige Hilfsschicht (B) aufgebracht wird, in einem zweiten Schritt eine Metallschicht (C) aus für die Gate-Metallisierung vorgesehenem hochtemperaturfestem Metall ganzflächig abgeschieden wird, in einem dritten Schritt diese Metallschicht (C) bis auf seitlich der Hilfsschicht (B) verbleibende erste und zweite Spacer (D, E) rückgeätzt wird, in einem vierten Schritt mittels einer Implantation von Dotierung die Source- und Drain-Bereiche (A', A'') ausgebildet werden, wobei die Hilfsschicht (B) mit den Spacern (D, E) als Maske dient, in einem fünften Schritt der den Source-Bereich (A') begrenzende erste Spacer (D) mit einer justierten Lackmaske (F) abgedeckt und der den Drain-Bereich (A'') begrenzende zweite Spacer (E) abgeätzt wird und in einem sechsten Schritt eine Source-Metallisierung (G) auf dem Source-Bereich (A') und eine Drain-Metallisierung (H) auf dem Drain-Bereich (A'') aufgebracht werden.

2. Verfahren nach Anspruch 1, bei dem in einem siebten Schritt eine zwischen der Source-Metallisierung (G) und den die Gate-Metallisierung bildenden ersten Spacer (D) und zwischen der Drain-Metallisierung (H) und dem ersten Spacer (D) verlaufende Passivierungsschicht (N) aus einem Dielektrikum aufgebracht wird.

3. Verfahren nach Anspruch 2, bei dem der siebte Schritt durchgeführt wird, indem ganzflächig eine Dielektrikumschicht (I) und darauf eine Lackschicht (J) mit ebener Oberfläche aufgebracht werden und dann mittels eines Ätzverfahrens dieser Dielektrikumschicht (I) und diese Lackschicht (J) soweit abgetragen werden, daß zumindest Anteile der Oberflächen der Source-Metallisierung (G), der Drain-Metallisierung (H) und der Gate-Metallisierung freigelegt werden und von der Dielektrikumschicht (I) solche Anteile zwischen der Source-Metallisierung (G), dem ersten Spacer (D) und der Drain-Metallisierung (H) als Passivierungsschicht (N) stehenbleiben, daß die freie Oberfläche der Source-Metallisierung (G), der Drain-Metallisierung (H), der Gate-Metallisierung und dieser Passivierungsschicht (N) zusammen eine mindestens im wesentlichen ebene Fläche bilden.

4. Verfahren nach Anspruch 2, bei dem der siebte Schritt ausgeführt wird, indem eine Dielektrikumschicht (I) aufgebracht wird, danach Kontaktlöcher für den Source-Bereich (A') und den Drain-Bereich (A'') in diese Dielektrikumschicht (I) geätzt werden und die Oberfläche der Gate-Metallisierung zumindest teilweise freigelegt wird und dann die Source-Metallisierung (G) und die Drain-Metallisierung (H) abgeschieden werden.

5. Verfahren nach einem der Ansprüche 1 bis 4, bei dem ein Temperschritt zur Ausheilung der Dotierung vor dem Abätzen des zweiten Spacers (E) erfolgt.

6. Verfahren nach einem der Ansprüche 1 bis 4, bei dem ein Temperschritt zur Ausheilung der Dotierung nach dem Abätzen des zweiten Spacers (E) erfolgt.

7. Verfahren nach Anspruch 6, bei dem nach dem Abätzen des zweiten Spacers (E) und vor dem Temperschritt eine LDD-Implantation (lightly doped drain) in den Drain-Bereich (A") durchgeführt wird.

8. Verfahren nach einem der Ansprüche 1 bis 7, bei dem nach dem vierten Schritt die Hilfsschicht (B) entfernt wird.

9. Verfahren nach einem der Ansprüche 1 bis 7, bei dem die Hilfsschicht (B) ein Dielektrikum ist und als Passivierung stehenbleibt.

10. Verfahren nach Anspruch 9, bei dem in dem ersten Schritt auf die Hilfsschicht (B) ein mit dieser Hilfsschicht (B) kantenkonform verlaufender Metallstreifen (d) aufgebracht wird,
in dem zweiten Schritt das Metall der Metallschicht (C) so gewählt wird, daß sich dieses Metall bezüglich des Metallstreifens (d) selektiv ätzen läßt, und der dritte Schritt so ausgeführt wird, daß der Metallstreifen (d) stehenbleibt und daß zumindest der erste Spacer (D) in elektrischem Kontakt mit dem Metallstreifen ist.

## FIG.1

## FIG.2

## FIG.3

## FIG.4

# FIG.5

# FIG.6

FIG 7

FIG 8

FIG 9

FIG 10

FIG 11

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 177 129 (TOSHIBA K.K.) <br> * Figur 1 * <br> --- | 1 | H 01 L 21/338 |
| A | EP-A-0 113 059 (IBM CORP.) <br> * Figuren 4,5; Zusammenfassung * <br> --- | 1,9,10 | |
| A | US-A-4 729 966 (TOSHIBA K.K.) <br> * Figuren 2,3 * <br> ----- | 1 | |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| DEN HAAG | 17-04-1990 | GELEBART J.F.M. |